# EUROPEAN PATENT SPECIFICATION

(11) **EP 2 255 600 B1**
(45) Date of publication and mention of the grant of the patent: **13.02.2013**
(21) Application number: 09721483.7
(22) Date of filing: 20.03.2009
(51) Int. Cl.: H05G 2/00

(54) **A TARGET MATERIAL, A SOURCE, AN EUV LITHOGRAPHIC APPARATUS AND A DEVICE MANUFACTURING METHOD USING THE SAME**
ZIELMATERIAL, QUELLE, EUV-LITHOGRAPHIEVORRICHTUNG UND GERÄTEHERSTELLUNGSVERFAHREN UNTER DEREN VERWENDUNG
MATÉRIAU CIBLE, SOURCE, APPAREIL LITHOGRAPHIQUE EUV ET PROCÉDÉ DE FABRICATION DU DISPOSITIF L UTILISANT

(30) Priority: 21.03.2008 US 64720
(43) Date of publication of application: 01.12.2010
(73) Proprietor: ASML Netherlands B.V., 5504 DR Veldhoven (NL)
(72) Inventor: KRIVTSUN, Vladimir Mihailovitc, Troitsk 142190 (RU); BANINE, Vadim Yevgenyevich, NL-5704 NK Helmond (NL); BLEEKER, Arno Jan, NL-5563 CE Westerhoven (NL); IVANOV, Vladimir Vitalevitch, Moskou 119421 (RU); KOSHELEV, Konstantin Nikolaevitch, Troitzk (RU); MOORS, Johannes Hubertus Josephina, NL-5709 MT Helmond (NL); CHURILOV, Sergey, Troitsk Moscow Region 142190 (RU); GLUSHKOV, Denis, D- 53347, Alfter (DE)
(86) International application number: PCT/NL2009/050132
(87) International publication number: WO 2009/116867

(56) References cited:
- WO-A-2004/044249
- WO-A-2009/078722
- JP-A- 2006 332 552
- JP-A- 2009 043 573
- US-A- 4 866 517
- US-A- 5 454 998
- US-A1- 2004 264 644
- US-A1- 2006 133 574
- US-A1- 2008 048 133
- EDWARD D. PALIK: "Handbook of Optical Constants of Solids" 1998, ACADEMIC PRESS , USA , XP002543561 ISBN: 0-12-544423-0 page 297 - page 298

## Description

### FIELD

The present invention relates to a target material, a source and an EUV lithographic apparatus comprising gadolinium.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) of a substrate (e.g. a silicon wafer). Transfer of the pattern is typically enabled via imaging onto a layer of radiation-sensitive material (resist) provided on the substrate. In general, a single substrate will contain a network of adjacent target portions that are successively patterned. Known lithographic apparatuses include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In particular, lithographic apparatuses are known which utilize radiation in a 13.5 nm range, or even in a 6.8 nm range. For the latter, gadolinium (Gd) targets or targets comprising gadolinium compounds are known. For example, United States Patent Application Publication No. 2006/0133574 A1 describes a lithographic apparatus having a Gd target conceived to generate a 6.8 nm beam, wherein the 6.8 nm radiation is generated using laser produced plasma (LPP). In order to bring the laser absorption region of the EUV light emission region closer, or to make them overlap, the known Gd target is configured to have a density in a range 0f 0.5% - 80% of a crystal density of gadolinium or its compound, for example gadolinium oxide.

### SUMMARY

It is technically demanding in the known lithographic apparatus to generate droplets of gadolinium to generate laser produced plasma due to high melting temperature of Gd, which is about 1313 °C. Also, a Gd target having a reduced density is not suitable for use with different EUV radiation generation means or radiation generators.

It is an aspect of the present invention to provide a target material to be used in a source constructed and arranged to be used in a lithographic apparatus which may be versatile with respect to the radiation generation means or radiation generator.

According to an aspect of the invention, there is provided a target material to be used in a source constructed and arranged to generate a radiation beam having a wavelength in an extreme ultraviolet range. The target material comprises a Gd-based composition configured to modify a melting temperature of Gd.

The target material may comprise a plurality of pre-fabricated solid droplet. For forming these droplets, the Gd-based composition may be embedded in a binder material for forming the solid droplets. The Gd-composition may include a colloidal compound of a Gd eutectic alloy.

The composition is configured to decrease the melting temperature of Gd.

According to an aspect of the invention, there is provided a source for use in a lithographic apparatus comprising a target material as is described in the foregoing.

According to an aspect of the invention there is provided a lithographic apparatus comprising a source as is described with reference to the foregoing. The radiation beam may be generated using a laser-produced plasma (LPP) source, or a discharge-produced plasma (DPP) source.

The lithographic apparatus may further comprise an illumination system configured to condition the radiation beam, a support constructed to support a patterning device, the patterning device being capable of imparting the radiation beam with a pattern in its cross-section to form a patterned radiation beam, a substrate table constructed to hold a substrate, and a projection system configured to project the patterned radiation beam onto a target portion of the substrate.

According to an aspect of the invention, there is provided a radiation source comprising a Gd-based composition configured to decrease the melting temperature of Gd, and a laser source configured to deliver a laser beam to the target material to generate the radiation beam.

According to an aspect of the invention, there is provided a lithographic apparatus that includes a radiation source configured to generate a radiation beam of extreme ultraviolet radiation. The radiation source comprises a Gd-based composition configured to decrease the melting temperature of Gd, and a laser source configured to deliver a laser beam to the target material to generate the radiation beam. The apparatus also includes an illumination system configured to condition the radiation beam, and a support constructed to support a patterning device. The patterning device is capable of imparting the radiation beam with a pattern in its cross-section to form a patterned radiation beam. The apparatus also includes a substrate table constructed to hold a substrate; and a projection system configured to project the patterned radiation beam onto a target portion of the substrate.

According to yet another aspect, there is provided a target material for generating a radiation beam having a wavelength in an extreme ultraviolet range, said target comprising Gd configured as a plurality of pre-fabricated solid droplets. According to yet a further aspect, such a target material may be comprised in a radiation source which may be included in a lithographic apparatus. The radiation beam may be generated using a laser-produced plasma (LPP) or a discharge-produced plasma (DPP). The lithographic apparatus may further comprise an illumination system configured to condition the radiation beam, a support constructed to support a patterning device, the patterning device being capable of imparting the radiation beam with a pattern in its cross-section to form a patterned radiation beam, a substrate table constructed to hold a substrate, and a projection system configured to project the patterned radiation beam onto a target portion of the substrate.

### BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1 depicts in a schematic way a lithographic apparatus according to an embodiment of the invention;

Figure 2 depicts in a schematic way an embodiment of an arrangement for laser produced plasma;

Figure 3 depicts in a schematic way an embodiment of an arrangement for discharge produced plasma;

Figure 4 depicts in a schematic way an embodiment of a Gd target configured as a plurality of solid droplets.

### DETAILED DESCRIPTION

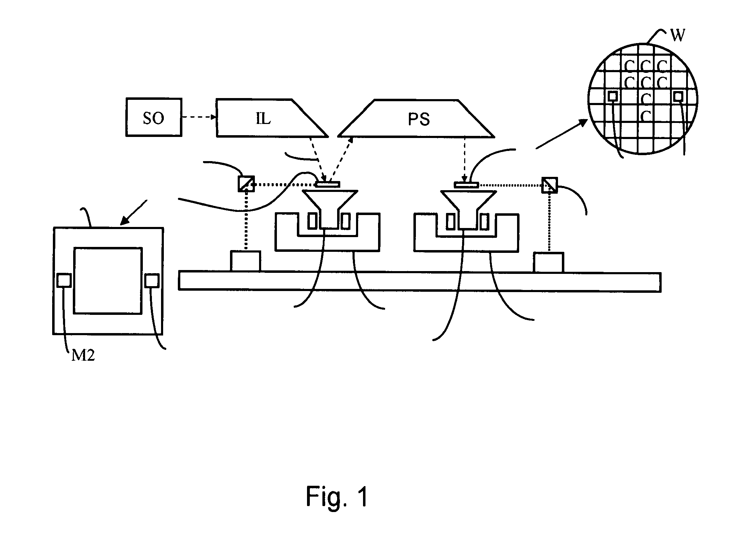

Figure 1 schematically depicts a lithographic apparatus according to one embodiment of the invention. The apparatus comprises: an illumination system (illuminator) IL configured to condition a radiation beam B having wavelength of about 6.8 nm; a support structure (e.g. a mask table) MT constructed to support a patterning device (e.g. a mask) MA and connected to a first positioner PM configured to accurately position the patterning device in accordance with certain parameters; a substrate table (e.g. a wafer table) WT constructed to hold a substrate (e.g. a resist-coated wafer) W and connected to a second positioner PW configured to accurately position the substrate in accordance with certain parameters; and a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as, for example, whether or not the patterning device is held in a vacuum environment. The support structure can use mechanical, vacuum, electrostatic or other clamping techniques to hold the patterning device. The support structure may be a frame or a table, for example, which may be fixed or movable as desired. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section so as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including reflective, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a reflective type (e.g. employing a reflective mask). Alternatively, the apparatus may be of a transmissive type (e.g. employing a transmissive mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

Referring to Figure 1, the illuminator IL receives a radiation beam from a radiation source SO. The source in accordance with the invention comprises a target material constructed for generating a radiation beam having wavelength of about 6.8 nm. The target material comprises a Gd-based composition configured to modify a melting temperature of pure Gd. In particular, the Gd-composition is selected to decrease the melting temperature of pure Gd. The is is particularly advantageous for use in a laser produced plasma (LPP) source. Due to the fact that the melting temperature of pure Gd is about 1313 °C, formation of droplets conceived to be impinged by a lased beam is technically difficult. By substantially decreasing the melting temperature due to usage of eutectic alloys of Gd instead of pure Gd as the target material, generation of LPP may be substantially simplified. For example, the following eutectic alloys listed in Table I are suitable for use as EUV targets emitting radiation with a wavelength of about 6.8 nm.

**Table 1: Eutectic Alloys**

| Eutectic alloy | Melting temperature, °C | Atomic weight of Gd, % |
|---|---|---|
| Gd:Ag | 790 | 77.5 |
| Gd:Cu | 675 | 70 |
| Gd:Ni | 635 | 65 |
| Gd:Fe | 845 | 70 |
| Gd:Co | 650 | 62 |
| Gd:Mn | 830 | 65 |
| Gd:Al | 875 | 77 |
| Gd:Ga | 850 | 80 |
| Gd:Cd | 920 | 80 |
| Gd:Ru, Rh | 925 | 82 |

It may be more desirable to use eutectic alloys of Gd:Cu, Gd:Ni, or Gd:Co due to a decrease of the original melting temperature of gadolinium by a factor of two for a given mass percentage of gadolinium in respective alloys. Eutectic alloys suitable for use as a target material for a lithographic apparatus are not limited to the specified Gd mass percentage, but that the percentage of Gd atomic weight in any specified eutectic alloy may be in the range of about 60 percent to about 90 percent. Eutectic alloys are not limited to bimetal alloys, but may comprise three or more metals.

It is found that eutectic alloys next to reducing melting temperature of pure gadolinium have a supplementary advantage in that lighter contamination may be produced in comparison with pure gadolinium targets. Droplets as targets may have an advantage of producing less contamination compared to massive targets, in particular, when a droplet comprises an optimum amount of radiation-generating material. In particular, when a droplet comprises less of such material than optimum, an overheating of the droplet by a laser beam may occur. In case when the droplet comprises more of such material than optimum, then a relatively cold material is abundant, which may contaminate and absorb the generated EUV radiation. The solid droplets may be dimensioned in a range of 10 - 100 micrometers, preferably in the range 10 - 50 micrometers and, thus, may be configured to comprise an optimum amount in the range of about 10¹³-10¹⁶ of Gd atoms for generation of the 6.8 nm beam.

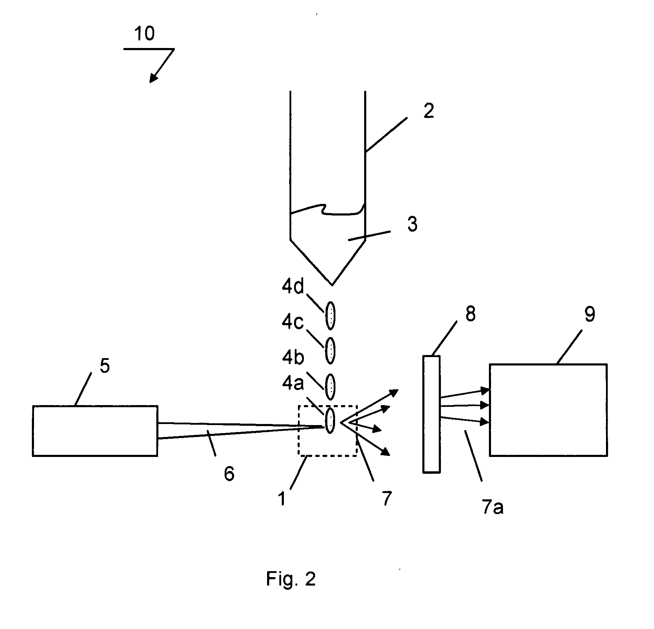

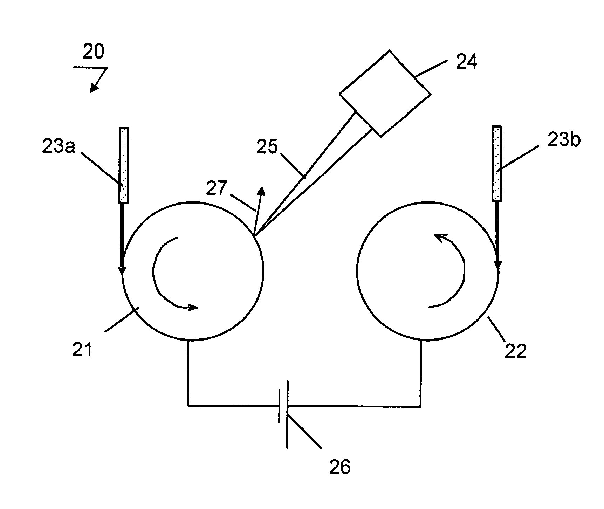

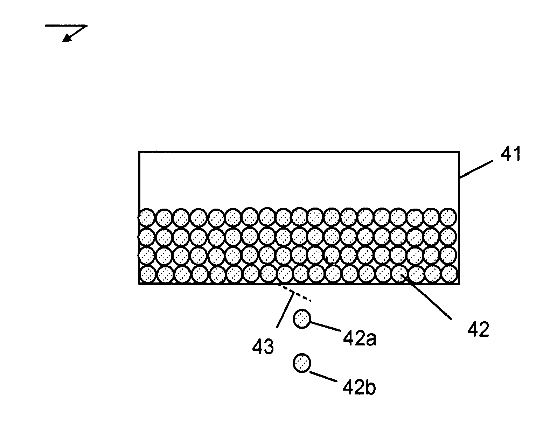

The target material that comprises Gd with decreased melting temperature may comprise a plurality of pre-fabricated solid droplets. An optimum amount of Gd atoms in such solid droplets may also be in the range of 10¹³-10¹⁶ atoms for a droplet size in the range of 10 - 100 micrometers. This presents a technically simplified equivalent to conventional LPP which uses fluid droplets. In this way, substantial amount of energy required for generating the 6.8 nm radiation beam may be saved, because a step of generating liquid droplets from a massive target may be avoided. The Gd-based eutectic alloy may be embedded in a binder material, like plastic, for forming the solid droplets. The solid droplets may then be provided in a vicinity of the laser beam for generating the 6.8 nm radiation. More details of the LPP source will be discussed below with reference to Figure 2.

In an embodiment, a solid droplet may be formed by a suitable Gd eutectic alloy being provided as a colloidal compound with a further suitable element. This may have an advantage of a simplified droplet preparation.

Solid targets can be adapted for use with a discharge produced plasma (DPP) source or a laser produced plasma source (LPP), wherein the formation of a liquid droplet is not desired. More details on a DPP source will be presented with reference to Figure 3.

A source comprising a suitable target material and a lithographic apparatus may be separate entities. In such cases, the source is not considered to form part of the lithographic apparatus and the radiation beam is passed from the source SO to the illuminator IL with the aid of a beam delivery system comprising, for example, suitable directing mirrors and/or a beam expander. In other cases the source may be an integral part of the lithographic apparatus. The source SO and the illuminator IL, together with the beam delivery system if desired, may be referred to as a radiation system.

The illuminator IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator and a condenser. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF2 (e.g. an interferometric device, linear encoder or capacitive sensor), the substrate table WT can be moved accurately, e.g. so as to position different target portions C in the path of the radiation beam B. Similarly, the first positioner PM and another position sensor IF1 can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribelane alignment marks). Similarly, in situations in which more than one die is provided on the mask MA, the mask alignment marks may be located between the dies.

The depicted apparatus could be used in at least one of the following modes:

1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

Figure 2 depicts in a schematic way an embodiment of an arrangement for a laser produced plasma source 10. The arrangement 10 comprises a container 2 arranged with a liquefied target material with a suitable eutectic Gd alloy 3. The container 2 may be arranged with a suitable mechanism or opening (not shown) for delivery of liquid droplets 4a, 4b, 4c, 4d of the Gd target material to the region 1 wherein the droplet is positioned to be impinged by a laser beam 6 provided by a laser source 5. The laser beam 6 is preferably focused in a region 1 using a suitable optical system (not shown). Upon interaction with the laser beam 6, the droplets 4a, 4b, 4c, 4d are transferred into plasma state which emits the 6.8 nm radiation, characteristic to relaxation of Gd atoms by means of suitable electronic transitions, for example 4d-4f transitions.

An emanating EUV 6.8 nm beam 7 may be intercepted by a suitable debris mitigation system 8 configured to collect or to deflect particle debris emanating from the region 1. An EUV beam 7a substantially free of debris may then enter an illumination system 9 constructed and arranged to suitably condition the beam 7a.

Figure 3 depicts in a schematic way an embodiment of an arrangement for a discharge produced plasma (DPP) source. The arrangement 20 may comprise two rotating bodies 21, 22, surfaces of which are arranged to be at least partially covered with liquid Gd eutectic alloy, which may be supplied from suitable delivery containers 23a, 23b. The bodies 21, 22 are kept under high voltage 26 to initiate discharge and may be rotatable in a direction towards each other, as is schematically indicated by arrows. In order to generate an EUV beam 27 having a wavelength about 6.8 nm, the target material is irradiated with a suitable focused laser beam 25, which is generated by a laser source 24. It will be appreciated that other per se known arrangements for generating discharge produced plasma may be applicable as well.

Figure 4 depicts in a schematic way an embodiment of a Gd target 40 configured as a plurality of solid droplets 42. The Gd target 40 may comprise a suitable composition of solid droplets, which may be provided in a suitable container 41. The solid droplets may be dimensioned in a range of 10 - 100 micrometers, preferably in the range 10 - 50 micrometers and, thus, may be configured to comprise a desired substantially optimum amount of Gd atoms for generation of the 6.8 nm beam. A computation of the desired optimum amount of Gd atoms regarding optimal heating temperature of the droplet lies within knowledge of the skilled artisan. The container 41 may comprise an opening port 43 for delivering individual droplets 42a, 42b to the outside of the container. The individual droplets 42a, 42b may be delivered in a region where a suitably adapted laser beam is present for generation of the EUV radiation, such as the laser beam 6 described above and shown in Figure 2.

Solid droplets relate to suitable eutectic alloys. By using such pre-fabricated solid droplets, there is no need to liquefy the gadolinium. This may have an advantage of saving a substantial amount of energy for generation of 6.8 nm radiation for lithography.

In an embodiment, the solid droplets 42 may comprise a colloid compound of Gd eutectic alloy particle with a further element.

Such a colloid compound may be bound using a suitable binder material, for example plastic, wherefrom solid droplets are produced.

Although solid droplets 42 are depicted as having a substantially round cross-section, other configurations, like cubes, prisms, ovals or cylinders is possible.

A lithographic apparatus as is discussed with reference to the foregoing target materials may be configured for generating said radiation beam using either a laser produced plasma (LPP) source, or a discharge produced plasma (DPP) source.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein relates to EUV radiation, in particular having wavelength of about 6.8 nm.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. A target material adapted for use in a source constructed and arranged to generate a radiation beam having a wavelength in an extreme ultraviolet range, said target material comprising a Gd-based composition configured to modify a melting temperature of Gd, wherein said composition is configured to decrease the melting temperature of Gd, wherein the composition comprises an eutectic alloy of Gd with a further element.

2. A target material according to claim 1, wherein the further element is selected from the group consisting of: Ag, Cu, Ni, Fe, Co, Mn, Al, Ga, Cd, Ru, and Rh.

3. A target material according to claim 1 or 2, wherein a percentage of Gd atomic weight in the eutectic alloy is in the range of about 60 percent to about 90 percent.

4. A target material according to any one of the preceding claims, wherein the target material comprises a plurality of pre-fabricated solid droplets.

5. A radiation source comprising a target material according to any one of the preceding claims.

6. A lithographic apparatus comprising a source according to claim 5.

## Patentansprüche

1. Ein Targetmaterial, das zur Verwendung in einer Quelle, die konstruiert und eingerichtet ist, um einen Strahlungsstrahl mit einer Wellenlänge in einem Extrem-Ultraviolettbereich zu erzeugen, angepasst ist, wobei das Targetmaterial eine Gdbasierte Zusammensetzung beinhaltet, die konfiguriert ist, um eine Schmelztemperatur von Gd zu modifizieren, wobei die Zusammensetzung konfiguriert ist, um die Schmelztemperatur von Gd zu senken, wobei die Zusammensetzung eine eutektische Legierung von Gd mit einem weiteren Element beinhaltet.

2. Targetmaterial gemäß Anspruch 1, wobei das weitere Element ausgewählt ist aus der Gruppe, bestehend aus: Ag, Cu, Ni, Fe, Co, Mn, Al, Ga, Cd, Ru und Rh.

3. Targetmaterial gemäß Anspruch 1 oder 2, wobei ein Prozentsatz des Gd-Atomgewichts in der eutektischen Legierung in dem Bereich von etwa 60 Prozent bis etwa 90 Prozent liegt.

4. Targetmaterial gemäß einem der vorhergehenden Ansprüche, wobei das Targetmaterial eine Vielzahl von vorgefertigten festen Tröpfchen beinhaltet.

5. Eine Strahlungsquelle, die ein Targetmaterial gemäß einem der vorhergehenden Ansprüche beinhaltet.

6. Ein lithographisches Gerät, das eine Quelle gemäß Anspruch 5 beinhaltet.

## Revendications

1. Un matériau cible conçu pour être utilisé dans une source construite et arrangée pour générer un faisceau de rayonnement ayant une longueur d'onde comprise dans une gamme d'ultraviolet extrême, ledit matériau cible comprenant une composition à base de Gd configurée pour modifier une température de fusion du Gd, ladite composition étant configurée pour abaisser la température de fusion du Gd, la composition comprenant un alliage eutectique de Gd avec un autre élément.

2. Un matériau cible selon la revendication 1, dans lequel l'autre élément est sélectionné dans le groupe consistant en : Ag, Cu, Ni, Fe, Co, Mn, Al, Ga, Cd, Ru, et Rh.

3. Un matériau cible selon la revendication 1 ou la revendication 2, dans lequel un pourcentage de masse atomique du Gd dans l'alliage eutectique est compris dans la gamme allant d'environ 60 pour cent à environ 90 pour cent.

4. Un matériau cible selon l'une quelconque des revendications précédentes, dans lequel le matériau cible comprend une pluralité de gouttelettes solides préfabriquées.

5. Une source de rayonnement comprenant un matériau cible selon l'une quelconque des revendications précédentes.

6. Un appareil lithographique comprenant une source selon la revendication 5.
